# EUROPEAN PATENT SPECIFICATION

(11) **EP 3 720 714 B1**
(45) Date of publication and mention of the grant of the patent: **22.02.2023**
(21) Application number: 18821827.5
(22) Date of filing: 29.11.2018
(51) Int. Cl.: B41F 15/08, B41F 15/42, H05K 3/12

(54) **MATERIAL TEMPERATURE SENSOR FOR STENCIL PRINTER**
MATERIALTEMPERATURSENSOR FÜR SCHABLONENDRUCKER
CAPTEUR DE TEMPÉRATURE DE MATÉRIAU POUR IMPRIMANTE AU POCHOIR

(30) Priority: 05.12.2017 US 201715831800
(43) Date of publication of application: 14.10.2020
(73) Proprietor: Illinois Tool Works, Inc., Glenview, Illinois 60025 (US)
(72) Inventor: MATTERO, Patsy A., Glenview IL 60025 (US); LYNCH, James, Glenview IL 60025 (US); DONELAN, Michael E., Glenview IL 60025 (US); PRENTICE, Thomas, C., Glenview IL 60025 (US); KING, Kenneth J., Glenview IL 60025 (US)
(74) Representative: HGF
(86) International application number: PCT/US2018/062945
(87) International publication number: WO 2019/112864

(56) References cited:
- EP-A1- 1 656 256
- EP-A2- 2 279 821
- US-A- 4 515 297
- US-B1- 6 395 334
- US-B1- 6 453 810

## Description

### BACKGROUND OF THE DISCLOSURE

### 1. Field of the Disclosure

The present disclosure relates to an apparatus and process for dispensing material, and more specifically to an apparatus and process for dispensing solder paste in a screen or stencil printer.

### 2. Discussion of Related Art

In surface-mount circuit board manufacturing operations, a stencil printer can be used to print solder paste onto a circuit board. Typically, a circuit board having a pattern of pads or some other, usually conductive, surface onto which solder paste will be deposited is automatically fed into the stencil printer and one or more small holes or marks on the circuit board, called fiducials, is used to properly align the circuit board with the stencil or screen of the stencil printer prior to the printing of solder paste onto the circuit board. In most systems, an optical alignment system is used to align the circuit board with the stencil.

Once the circuit board has been properly aligned with the stencil in the printer, the circuit board is raised to the stencil, solder paste is dispensed onto the stencil, and a wiper blade (or squeegee) traverses the stencil to force the solder paste through apertures in the stencil and onto the board. As the squeegee is moved across the stencil, the solder paste tends to roll in front of the blade, which desirably causes mixing and shearing of the solder paste so as to attain desired viscosity to facilitate filling of the apertures in the screen or stencil. The solder paste is typically dispensed onto the stencil from a standard cartridge, such as that manufactured by SEMCO Corporation.

Known systems to control material temperature are directed to heating the material after the material leaves the original packaging, e.g., the cartridge. Reference can be made to U.S. Patent No. 6,453,810, which discloses that a heater and/or cooler, along with a feedback mechanism (thermocouple or RTD in contact with the direct contact with the material) can be employed with a PID controller to stabilize the paste temperature within a material disposition chamber. The system does not use the temperature information for any other reason and is only used within the control loop.

### SUMMARY OF THE DISCLOSURE

In one aspect of the invention, a print head assembly of a stencil printer according to claim 1 is provided.

In a further aspect of the invention, a method of printing an assembly material on an electronic substrate according to claim 10 is provided.

In yet a further aspect of the invention, a stencil printer for printing an assembly material on an electronic substrate according to claim 13 is provided.

Preferred embodiments of the invention are claimed in the dependent claims.

### BRIEF DESCRIPTION OF THE DRAWINGS

Various aspects of at least one embodiment are discussed below with reference to the accompanying figures, which are not intended to be drawn to scale. In the figures, each identical or nearly identical component that is illustrated in various figures is represented by a like numeral.

In the figures:
FIG. 1 is a front perspective view of a stencil printer in accordance with some embodiments of the disclosure;
FIG. 2 is a top plan view of the stencil printer illustrated in FIG. 1 with portions removed;
FIG. 3 is a perspective view of a print head assembly of the stencil printer;
FIG. 4 is a front view of the print head assembly;
FIG. 5 is a side view of a material temperature sensor of the print head assembly;
FIG. 6 is a perspective view of the material temperature sensor; and
FIG. 7 is a perspective view of another embodiment incorporating a material temperature sensor.

### DETAILED DESCRIPTION OF THE DISCLOSURE

For purposes of illustration, embodiments of the present disclosure will now be described with reference to a stencil printer used to print an assembly material, such as solder paste, onto a circuit board. One skilled in the art will appreciate, however, that embodiments of the present disclosure are not limited to stencil printers that print solder paste onto circuit boards, but rather, may be used in other applications requiring dispensing of other viscous assembly materials, such as glues and encapsulents. For example, the apparatus may be used to print epoxy for use as underfill for chip-scale packages. Further, stencil printers in accordance with embodiments of the present disclosure are not limited to those that print assembly materials on circuit boards, but rather, include those used for printing other materials on a variety of substrates, such as semiconductor wafers. Also, the terms screen and stencil may be used interchangeably herein to describe a device in a printer that defines a pattern to be printed onto a substrate. In certain embodiments, the stencil printer may include a Momentum^{®} or an Edison^{™} series stencil printer platform offered by ITW Electronic Assembly Equipment of Hopkinton, Massachusetts.

It is known in the SMT industry that the temperature of the printing materials (e.g., solder paste) has a direct effect on print release characteristics and overall print quality. Typically, within a material deposition system, there is a mechanism, such as a dispense axis or a pump, that holds the material supply and it is called for by the software during a print cycle to deposit this material on the stencil when required. Alternatively, this material may be applied by hand. When this material supply is first installed in the machine or when it is being replenished in the machine, the temperature of the material is unknown. It would be advantageous to measure the temperature of the material prior to depositing the material onto the stencil.

Embodiments of the present disclosure are directed to a non-contact (e.g., infrared) temperature probe that is mounted to measure the temperature of a material supply cartridge. The data collected from the sensor is utilized to determine if the material supply has warmed sufficiently from its refrigerated storage temperature to permit proper deposition of the material. The sensing capability will help to ensure that even before the material is transferred from the supply cartridge onto the stencil, that it is within a desired temperature range as defined by the machine operator or setup personnel.

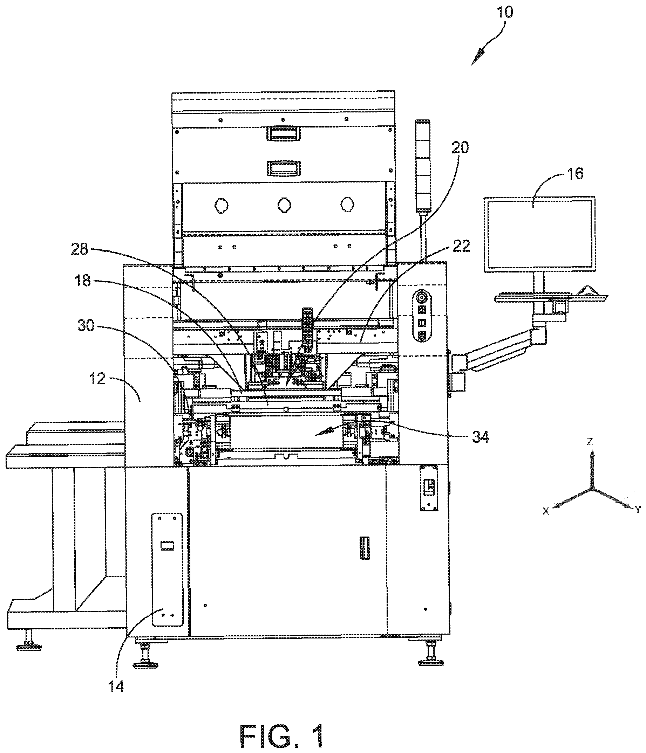

Referring now to the drawings, and more particularly to FIG. 1, there is generally indicated at 10 a stencil printer of an embodiment of the disclosure. As shown, the stencil printer 10 includes a frame 12 that supports components of the stencil printer. The components of the stencil printer include, in part, a controller 14, a display 16, a stencil 18, and a print head or print head assembly, generally indicated at 20, which is configured to apply the solder paste in a manner described in greater detail below.

As shown in FIG. 1 and described below, the stencil and the print head assembly are suitably coupled or otherwise connected to the frame 12. In one embodiment, the print head assembly 20 may be mounted on a print head assembly gantry 22, which may be mounted on the frame 12. The print head assembly gantry 22 enables the print head assembly 20 to be moved in the y-axis direction under the control of the controller 14 and to apply pressure on the print head assembly as it engages the stencil 18. In a certain embodiment, the print head assembly 20 is placed over the stencil 18 and is lowered in the z-axis direction into contact and sealingly engage the stencil.

The stencil printer 10 may also include a conveyor system having rails (not shown) for transporting a printed circuit board (sometimes referred to as a "printed wiring board," "substrate," or "electronic substrate" herein) to a print position in the stencil printer. The rails sometimes may be referred to herein as a "tractor feed mechanism," which is configured to feed, load or otherwise deliver circuit boards to the working area of the stencil printer, which may be referred to herein as a "print nest," and to unload circuit boards from the print nest.

The stencil printer 10 has a support assembly 28 to support the circuit board 29 (shown in dashed lines), which raises and secures the circuit board so that it is stable during a print operation. In certain embodiments, the substrate support assembly 28 further may include a particular substrate support system, e.g., a solid support, a plurality of pins or flexible tooling, which is positioned beneath the circuit board when the circuit board is in the print position. The substrate support system may be used, in part, to support the interior regions of the circuit board to prevent flexing or warping of the circuit board during the print operation.

In one embodiment, the print head assembly 20 may be configured to receive solder paste from a source, such as a dispenser, e.g., a solder paste cartridge, that provides solder paste to the print head assembly during the print operation. Other methods of supplying solder paste may be employed in place of the cartridge. For example, solder paste may be manually deposited between the blades or from an external source. Additionally, in a certain embodiment, the controller 14 may be configured to use a personal computer having a suitable operating system, such as a Microsoft Windows° operating system provided by Microsoft Corporation, with application specific software to control the operation of the stencil printer 10. The controller 14 may be networked with a master controller that is used to control a production line for fabricating circuit boards.

In one configuration, the stencil printer 10 operates as follows. A circuit board 29 is loaded into the stencil printer 10 using the conveyor rails. The support assembly 28 raises and secures the circuit board 29 to a print position. The print head assembly 20 is then lowered in the z-axis direction until blades of the print head assembly contact the stencil 18 at a desired pressure. The print head assembly 20 is then moved in the y-axis direction across the stencil 18 by the print head assembly gantry 22. The print head assembly 20 deposits solder paste through apertures in the stencil 18 and onto the circuit board 29. Once the print head assembly has fully traversed the stencil 18 across the apertures, the print head assembly is lifted off the stencil and the circuit board 29 is lowered back onto the conveyor rails. The circuit board 29 is released and transported from the stencil printer 10 so that a second circuit board may be loaded into the stencil printer. To print on the second circuit board 29, the print head assembly is lowered in the z-axis direction into contact with the stencil and moved across the stencil 18 in the direction opposite to that used for the first circuit board.

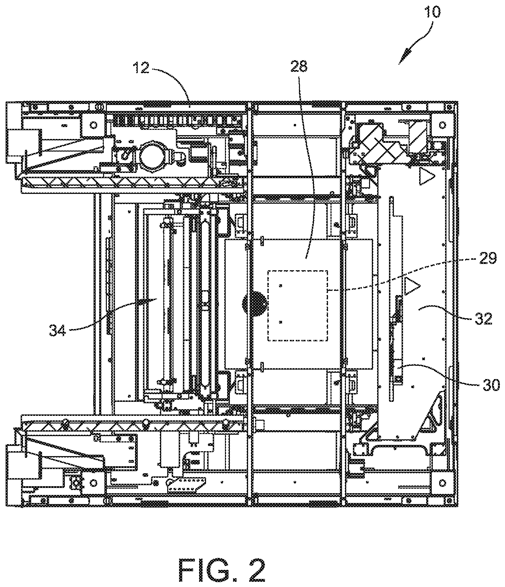

Referring additionally to FIG. 2, an imaging system 30 may be provided for the purposes of aligning the stencil 18 with the circuit board 29 prior to printing and to inspect the circuit board after printing. In one embodiment, the imaging system 30 may be disposed between the stencil 18 and the support assembly 28 upon which a circuit board is supported. The imaging system 30 is coupled to an imaging gantry 32 to move the imaging system. In one embodiment, the imaging gantry 32 may be coupled to the frame 12, and includes a beam that extends between side rails of the frame 12 to provide back and forth movement of the imaging system 30 over the circuit board 29 in a y-axis direction. The imaging gantry 32 further may include a carriage device, which houses the imaging system 30, and is configured to move along the length of the beam in an x-axis direction. The construction of the imaging gantry 32 used to move the imaging system 30 is well known in the art of solder paste printing. The arrangement is such that the imaging system 30 may be located at any position below the stencil 18 and above the circuit board 29 to capture an image of predefined areas of the circuit board or the stencil, respectively.

After one or more applications of the solder paste to circuit boards, excess solder paste may accumulate at the bottom of the stencil 18 and a stencil wiper assembly, generally indicated at 34, and may move beneath the stencil to remove the excess solder paste. In other embodiments, the stencil 18 may be moved over the stencil wiper assembly.

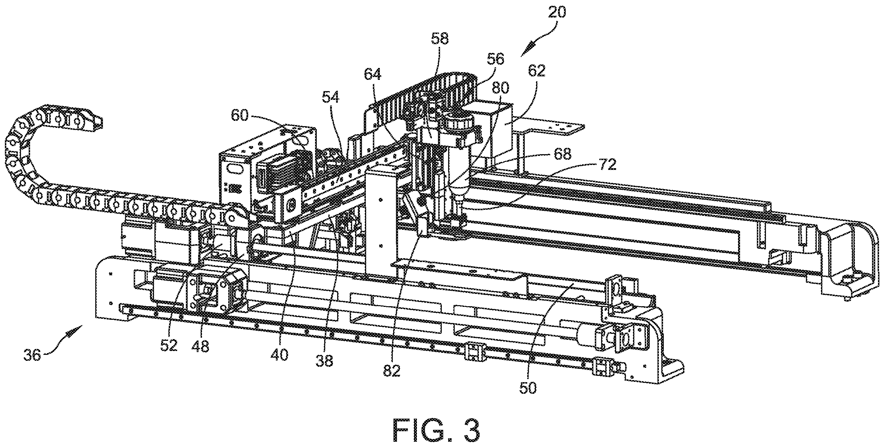

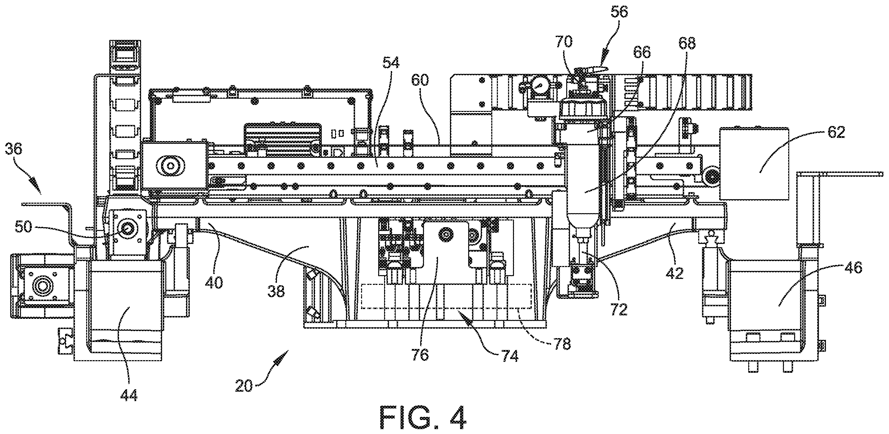

Referring to FIGS. 3 and 4, the print head assembly 20, which is capable of moving in three orthogonal axes, i.e., the x-axis, the y-axis and the z-axis directions, includes a print head frame, generally indicated at 36, coupled to the frame 12 of the stencil printer 10. Specifically, the print head frame 36 includes a main housing 38 having ends 40, 42 that extend laterally from the main housing. The main housing 38 functions as a cross beam to support the components of the print head assembly 20. The ends 40, 42 of the main housing 38 are configured to be slidably secured to a pair of rails 44, 46 provided on the frame 12 of the stencil printer 10. The end 40 includes a drive block 48 that threadably receives a ball screw 50, which is driven (rotated) by a motor 52. The arrangement is such that the print head frame 36 is configured to move along the rails 44, 46 of the stencil printer frame 12 by controlling the operation of the motor 52 with the controller 14, which is configured to control the operation of the print head assembly 20, including the motor.

The print head assembly 20 further includes a rail 54 that is secured to the main housing 38 of the print head frame 36. The rail 54 extends along a length of the main housing 38 between the ends 40, 42 of the print head frame 36. The print head assembly 20 further includes a dispensing unit, generally indicated at 56, mounted on a support bracket 58, which in turn is mounted on the rail 54 and configured to move along a length of the rail. A drive belt 60 driven by a motor 62 powers the movement of the dispensing unit 56 along the rail 54 to provide translational movement of the dispensing unit in a direction transverse to the direction of the print strokes. The provision of the rail 54, the support bracket 58, the drive belt 60 and the motor 62 together can be characterized as providing translational movement to the dispensing unit 56. The dispensing unit 56 is configured to move up and down in a z-axis direction by means of a sliding mechanism 64 associated with the support bracket 58 by a pneumatic actuator.

The dispensing unit 56 includes a cartridge receiver 66 that is configured to receive a cylindrically-shaped cartridge 68 designed to contain assembly material, such as solder paste. The cartridge 68 is releasably secured to the cartridge receiver 66 in the well-known manner. In another aspect of the disclosure, solder paste can be manually deposited on the stencil 18. As shown, the cartridge 68 is coupled to one end of a pneumatic air hose by a fitting 70 and the other end of the hose is attached to a compressor or suitable pressurized air source. The dispensing of solder paste from the cartridge 68 is controlled by the controller 14 to dispense solder paste on the stencil 18. Specifically, solder paste is dispensed through a port or nozzle 72 provided at the lower end of the cartridge receiver 66. A sensor (not shown) is provided to detect whether the cartridge is depleted or substantially depleted of solder paste.

The print head assembly 20 further includes a wiper blade assembly, generally indicated at 74, for forcing solder paste into the apertures of the stencil 18 during a print stroke. As shown, the wiper blade assembly 74 has a wiper blade holder 76 mounted on each side of the main housing 38 of the print head frame 36, with a wiper blade 78 being shown in dashed lines for clarity. In one embodiment, the wiper blade 78 can be secured to the main housing 38 by a clamping mechanism. The arrangement is such that one wiper blade 78 is adapted to print solder paste when the print head assembly 20 is traveling in one direction during a print stroke. Upon completion of the print stroke, the substrate (e.g., a circuit board) is ejected from the stencil printer 10 and a subsequent substrate is delivered to the stencil printer and positioned therein for printing. Next, the other wiper blade, provided on the other side of the main housing 38 (not shown), forces solder paste into the apertures of the stencil 18 while the print head assembly 20 travels in an opposition direction during another print stroke.

The amount of solder paste dispensed between the wiper blades 78 is controlled by the controller 14, or, in another aspect of the disclosure, by the stencil printer operator. The nozzle 72 of the dispensing unit 56 is disposed in between the wiper blades 78, and solder paste is dispensed anywhere in a dispensing region defined by the wiper blades by lowering the dispensing unit by the sliding mechanism 64 and the pneumatic actuator along the z-axis direction so that the nozzle of the dispensing unit is disposed between the wiper blades. Translational movement of the dispensing unit 56 is caused by activating the motor 62 to dispense along the length of the wiper blades 78.

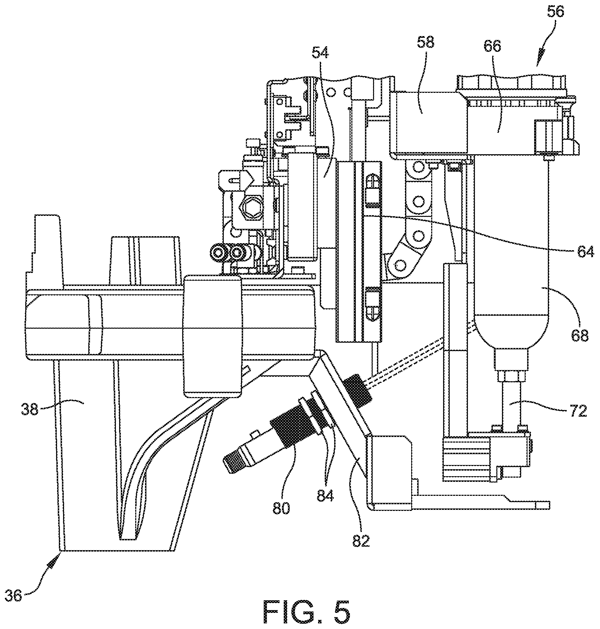

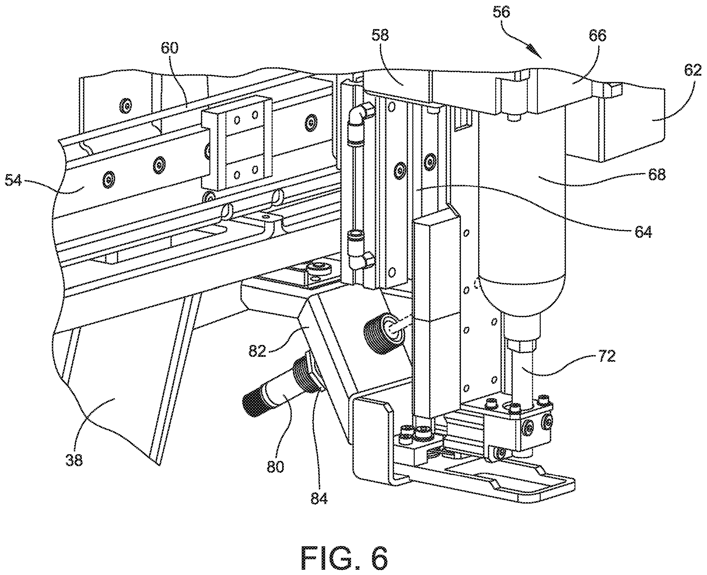

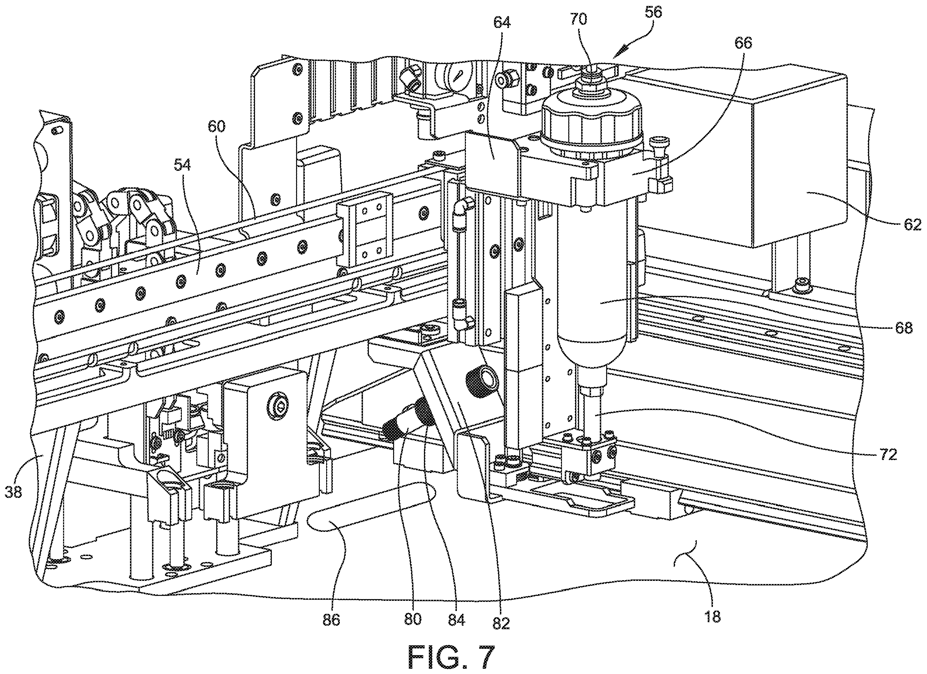

Referring to FIGS. 5 and 6, the dispensing unit includes a non-contact sensor 80 mounted on the main housing 38 of the print head frame 36 by a bracket 82. The non-contact sensor 80, which may embody an infrared sensor, is positioned to sense material in the cartridge 68 held by the cartridge receiver 66. Alternatively, the non-contact sensor 80 can be positioned to detect dispensed material on the stencil 18 when the material was applied by manually depositing the material on the stencil. This embodiment is described with reference to FIG. 7 below. The bracket 82 is configured to direct the non-contact sensor 80 toward the cartridge 68, and is generally at an angle with respect to the vertical orientation of the cartridge. A distance that the non-contact sensor 80 is spaced from the cartridge 68 by the bracket 82 depends on the type of non-contact sensor selected. For example, for one type of sensor, the sensor can be spaced from the cartridge 68 a distance of 3 millimeters (mm) to 1000 mm. In one embodiment, a sensing spot size generated by the non-contact sensor 80 corresponds to a spacing of the non-contact sensor 80 from the cartridge 68. Thus, by increasing a distance of the spacing of the non-contact sensor 80 from the cartridge 68, the sensing spot size is increased. Accordingly, a range for use within the print head assembly of embodiments of the present disclosure is a distance of 3 mm to 300 mm. In one embodiment, a distance of 75 mm is selected. In one embodiment, the non-contact sensor 80 is secured to the bracket by means of a threaded body and jam nuts, each indicated at 84, secured against both faces of the bracket 82. The bracket 82 is fabricated from a metal, such as aluminum or steel; however, other materials, such as a hard plastic, can be employed.

The non-contact sensor 80 is configured to detect a temperature of the material in the cartridge 68 to confirm whether the temperature is correct for the particular application, using criteria pre-determined by a user setup process in which the operator of the stencil printer 10 inputs settings for the stencil printer before the material is transferred from the cartridge. The non-contact sensor 80 is connected to the controller 14, and is configured to immediately notify the operator if the material is not ready for deposition. Additionally, temperature data can be collected by the controller 14 for every material dispense from the cartridge 68. The data collected can be fed back to the stencil printer 10 for additional actions, or it can be sent to a data collections systems, such as downstream machines or either internal or remote statistical processing.

In certain embodiments, the operator of the stencil printer 10 has a material supply process, wherein the material supply container(s) or cartridge(s), stored at refrigeration temperatures, are removed from the refrigerator prior to use in the stencil printer, ideally with sufficient time to reach a proper temperature before being installed in the machine. With use of the non-contact sensor 80, the operator can configure the stencil printer 10 to verify that the material in the cartridge 68 is indeed at the proper temperature before the material gets deposited onto the stencil 18 or into the chamber, in the case of an enclosed (pressurized) printing pump.

In certain embodiments, the non-contact sensor 80 is an infrared sensor to detect the temperature of the cartridge 68. The infrared sensor is an electronic sensor that is configured to measure infrared light that radiates from an object positioned in a field of view of the sensor. Objects having a temperature above absolute zero emit heat in the form of radiation. In a certain embodiment, the infrared sensor is a T-GAGE^{™} M18T Series Infrared Temperature Sensor offered by Banner Engineering Corporation of Minneapolis, Minnesota. The T-GAGE^{™} sensor is a passive, non-contact, temperature-based, sensor that is used to detect an object's temperature within a sensing window and output a proportional voltage or current, depending on the configuration of the sensor.

FIG. 7 illustrates the use of the non-contact sensor 80 secured to the bracket 82 so that the non-contact sensor is directed to the stencil 16. Specifically, the non-contact sensor 80 is secured to the bracket 82 to direct the non-contact sensor toward a deposit of solder paste 86. As with the embodiment described above with reference to FIGS. 5 and 6, a distance that the non-contact sensor 80 is spaced from the deposit of solder paste 86 by the bracket 82 depends on the type of non-contact sensor selected. As shown, the non-contact sensor 80 is secured to the bracket the threaded body and the jam nuts, which are secured against both faces of the bracket 82. The non-contact sensor 80 is configured to detect a temperature of the deposit of solder paste 86 to determine a temperature of the deposit prior to performing a stencil print operation. The non-contact sensor 80 is connected to the controller 14, and is configured to immediately notify the operator if the deposit of solder paste 86 is not ready for the stencil print operation.

Embodiments of the print heat assembly having the non-contact sensor described above is used to monitor the temperature of a supply cartridge of solder paste in a printer, at least in part to ensure that the solder paste reaches a proper temperature prior to initiating a print deposition. Embodiments of the print head assembly having the non-contact sensor described above further are used to ensure that the solder paste, when stored at a temperature lower than a proper application temperature, is warmed to a proper temperature for deposition.

Embodiments of the print head assembly having the non-contact sensor can also be used to measure a temperature of material to be deposited, but also the temperatures of the substrate, e.g., circuit board 29, upon which the material is to be deposited and the solder paste deposited on the stencil. For example, it is well known in the SMT assembly industry that the substrate in a dispenser is often preheated before deposition of underfill materials. Typical applications utilize what is known as a pre-heat "chuck" (an area or zone for heating a PCB to a pre-determined temperature), before it is transported into a dispense zone to receive the material to be dispensed. A problem with the preheat zone is that there is typically only one feedback sensor to measure a temperature of the entire pre-heat chuck, which is typically 330 mm X 250 mm. This feedback from a single sensor generally senses the temperature at one location, and the result is assumed to represent the temperature for the entire pre-heat zone, and does not necessarily reflect the actual temperature of a specific location of interest, for example the temperature of a critical component. Furthermore, without feedback of the actual temperature of specific location of the substrate, the time allocated to pre-heat the substrate is often selected to ensure that at least a sufficient time has passed for the temperature of the substrate to stabilize. This may mean that valuable time is wasted waiting for an excessively long "sufficient" time period.

A non-contact sensor, such as non-contact sensor 80, positioned above the substrate on the pre-heat chuck can be utilized to confirm that the substrate is indeed at the proper temperature before proceeding with the dispensing operation, without the need to wait longer than necessary to ensure that components of the system are at an adequate temperature. By mounting the non-contact sensor over a particular location on the substrate, the actual temperature of a critical location can be measured. Furthermore, by mounting the sensor to the deposition head (or other mechanism, such as a vision probe in a printer) that can move in the x-axis and y-axis directions over the substrate, the temperature of any specific spot can be measure. The non-contact sensor also may be mounted on a mechanism that moves towards and away from the target of the temperature measurement or the target can move in the x-axis, y-axis and z-axis directions relative to the sensor. Such a configuration permits the effective spot size of the sensor to be adjusted or tailored to the needs of the application. For example, the non-contact sensor may be mounted on a vertical stage, and oriented to look down at a substrate. By moving the vertical stage and sensor lower and thus closer to the substrate, the temperature of a smaller localized spot may be measured. By moving the vertical stage and sensor up and thus further from the substrate, the temperature to be measured may effectively be averaged over a larger area. This can also be achieved by moving the target relative to the sensor to specific locations and to achieve specific spot sizes. Such arrangements permit the sensing of a temperature averaged over a controllable size region, wherein the size of the sensing area may be optimized for the application requirements. Thus, by mounting the sensor to a Z stage, which is in turn mounted to an X-Y positioning system, for example, from a pump mounting bracket, both the location and the size of the spot can be controlled.

By implementing embodiments of the present disclosure, a deposition system can monitor the temperature of the materials to be dispensed by the piece of equipment, as well as the temperature of critical locations on the substrate upon which the material is to be dispensed, ensuring that all the participants in the deposition process are at the desired temperature. Each of these measured temperatures may be utilized to confirm that process variables are within a preset range prior to proceeding with the deposition process. Additionally (or perhaps alternatively), these measurements may be shared or stored for data collection purposes, such as statistical process control (SPC), wherein the quality or yield of a process may be correlated with measured variables in a process, for the purposes of process optimization.

In embodiments of the present disclosure, the provision of the non-contact sensor 80 can be applied to dispensers as well as printers. The materials supplied in the cartridges to be dispensed in a dispenser are often stored at temperatures even lower than those used for solder paste storage. For example, dispensers are sometimes used to dispense multi-part pre-mixed epoxies that must be kept frozen at industrial freezer temperatures, sometimes as low as -40 °C, to prevent premature curing. For such systems, the need to ensure that the material has reached an appropriate dispensing temperature can be critical.

## Claims

1. A print head assembly (20) of a stencil printer (10), the print head assembly (20) comprising:
a print head frame (36);
a wiper blade assembly (74) coupled to the print head frame (36), the wiper blade assembly (74) having wiper blades (78) that contact the stencil (18) to print solder paste onto the stencil (18) during a print stroke, the wiper blades (78) being configured to force solder paste through the apertures of the stencil (18);
a dispensing unit (56) coupled to the print head frame (36), the dispensing unit (56) being configured to deposit solder paste between the wiper blades (78), the dispensing unit (56) including a cartridge receiver (66); and
a cartridge (68) positioned in the cartridge receiver (66);
**characterized in that** the print head assembly further comprises:
a sensor (80) coupled to the print head frame (36) proximate the cartridge (68), the sensor (80) being configured to measure a temperature of the cartridge (68), wherein the sensor (80) is a non-contact sensor (80).

2. The print head assembly (20) of claim 1, wherein the non-contact sensor (80) is an infrared sensor.

3. The print head assembly (20) of claim 1, wherein the non-contact sensor (80) is secured to the print head frame (36) by a bracket (82).

4. A stencil printer (10) for printing an assembly material on an electronic substrate, the stencil printer (10) comprising:
a frame (12);
a stencil (18) coupled to the frame (12), the stencil (18) having apertures formed therein;
a support assembly (28) coupled to the frame (12), the support assembly (28) being configured to support the electronic substrate in a print position beneath the stencil (18); and
a print head assembly (20) of claim 1, coupled to the frame (12) in such a manner that the print head assembly (20) is configured to traverse the stencil (18) during print strokes.

5. The stencil printer (10) of claim 4, wherein the non-contact sensor (80) is an infrared sensor.

6. The stencil printer (10) of claim 4, wherein the non-contact sensor (80) is secured to the print head frame (36) by a bracket (82).

7. The stencil printer (10) of claim 6, wherein the bracket (82) is configured to orient the non-contact sensor (80) at an angle with respect to an orientation of the cartridge (68).

8. The stencil printer (10) of claim 4, wherein the print head assembly (20) further includes a translational movement assembly coupled to the frame (12) and the dispensing unit (56), the translational movement assembly being configured to move the dispensing unit (56) in a direction transverse to the direction of the movement of the print head assembly (20) during a print stroke.

9. The stencil printer (10) of claim 8, wherein the print head assembly (20) further includes a slide mechanism coupled to the frame (12) and the dispensing unit (56), the slide mechanism being configured to move the dispensing unit (56) up and down in a z-axis direction.

10. A method of printing an assembly material on an electronic substrate, the method comprising:
delivering an electronic substrate to a stencil printer (10);
positioning the electronic substrate in a print position;
engaging a stencil (18) having apertures to the electronic substrate;
performing a print stroke with a wiper blade (78) to force solder paste through the apertures of the stencil (18) on to the electronic substrate; and
depositing solder paste between wiper blades (78) during the print stroke; **characterized by**
measuring a temperature of the assembly material contained within a cartridge (68) using a sensor (80), wherein the sensor (80) is a non-contact sensor (80).

11. The method of claim 10, wherein the non-contact sensor (80) is an infrared sensor.

12. The method of claim 10, further comprising positioning the non-contact sensor (80) with respect to the cartridge (68) by a bracket (82).

13. A stencil printer (10) for printing an assembly material on an electronic substrate, the stencil printer (10) comprising:
a frame (12);
a stencil (18) coupled to the frame (12), the stencil (18) having apertures formed therein;
a support assembly (28) coupled to the frame (12), the support assembly (28) being configured to support the electronic substrate in a print position beneath the stencil (18); and
a print head assembly (20) coupled to the frame (12) in such a manner that the print head assembly (20) is configured to traverse the stencil (18) during print strokes, the print head assembly (20) including
a print head frame (36),
a wiper blade assembly (74) coupled to the print head frame (36), the wiper blade assembly (74) having wiper blades (78) that contact the stencil (18) to print solder paste onto the stencil (18) during a print stroke, the wiper blades (78) being configured to force solder paste through the apertures of the stencil (18), and
a dispensing unit (56) coupled to the print head frame (36), the dispensing unit (56) being configured to deposit solder paste between the wiper blades (78), the dispensing unit (56) including a cartridge receiver (66),
**characterized in that** the print head assembly further includes:
a sensor (80) coupled to the print head frame (36), the sensor (80) being configured to measure a temperature of the solder paste deposited by the dispensing unit (56), wherein the sensor (80) is a non-contact sensor (80).

14. The stencil printer (10) of claim 13, wherein the non-contact sensor (80) is an infrared sensor.

15. The stencil printer (10) of claim 13, wherein the non-contact sensor (80) is secured to the print head frame (36) by a bracket (82), the bracket (82) being configured to orient the non-contact sensor (80) at an angle with respect to the deposition of the solder paste.

## Patentansprüche

1. Druckkopfanordnung (20) eines Schablonendruckers (10), die Druckkopfanordnung (20) aufweisend:
einen Druckkopfrahmen (36);
eine mit dem Druckkopfrahmen (36) verbundene Wischerblattanordnung (74), wobei die
Wischerblattanordnung (74) die Schablone (18) berührende Wischerblätter (78) aufweist, um während eines Druckvorgangs Lötpaste auf die Schablone (18) zu drucken, wobei die Wischerblätter (78) ausgestaltet sind, Lötpaste durch die Öffnungen der Schablone (18) zu drücken;
eine mit dem Druckkopfrahmen (36) verbundene Abgabeeinheit (56), wobei die Abgabeeinheit (56) zum Aufbringen von Lötpaste zwischen den Wischerblättern (78) ausgestaltet ist, wobei die Abgabeeinheit (56) eine Patronenaufnahme (66) beinhaltet; und
eine in der Patronenaufnahme (66) angeordnete Patrone (68); **dadurch gekennzeichnet, dass** die Druckkopfanordnung ferner aufweist:
einen mit dem Druckkopfrahmen (36) in der Nähe der Patrone (68) verbundenen Sensor (80), wobei der Sensor (80) zur Messung einer Temperatur der Patrone (68) ausgestaltet ist, wobei der Sensor (80) ein berührungsloser Sensor (80) ist.

2. Druckkopfanordnung (20) nach Anspruch 1, wobei der berührungslose Sensor (80) ein Infrarotsensor ist.

3. Druckkopfanordnung (20) nach Anspruch 1, wobei der berührungslose Sensor (80) mit einer Halterung (82) an dem Druckkopfrahmen (36) befestigt ist.

4. Schablonendrucker (10) zum Drucken eines Montagematerials auf ein elektronisches Substrat, der Schablonendrucker (10) aufweisend:
einen Rahmen (12);
eine mit dem Rahmen (12) verbundene Schablone (18), wobei die Schablone (18) darin ausgebildete Öffnungen aufweist;
eine mit dem Rahmen (12) verbundene Trägeranordnung (28),
wobei die Trägeranordnung (28) zum Tragen des elektronischen Substrats in einer Druckposition unterhalb der Schablone (18) ausgestaltet ist; und
eine Druckkopfanordnung (20) nach Anspruch 1, die derart mit dem Rahmen (12) verbunden ist, dass die Druckkopfanordnung (20) zur Überquerung der Schablone (18) während der Druckhübe ausgestaltet ist.

5. Schablonendrucker (10) nach Anspruch 4, wobei der berührungslose Sensor (80) ein Infrarotsensor ist.

6. Schablonendrucker (10) nach Anspruch 4, wobei der berührungslose Sensor (80) mit einer Halterung (82) an dem Druckkopfrahmen (36) befestigt ist.

7. Schablonendrucker (10) nach Anspruch 6, wobei die Halterung (82) zum Ausrichten des berührungslosen Sensors (80) in einem Winkel relativ zu einer Ausrichtung der Patrone (68) ausgestaltet ist.

8. Schablonendrucker (10) nach Anspruch 4, wobei die Druckkopfanordnung (20) ferner eine mit dem Rahmen (12) und der Abgabeeinheit (56) verbundene Translationsbewegungsanordnung beinhaltet, wobei die Translationsbewegungsanordnung zur Bewegung der Abgabeeinheit (56) in einer Richtung quer zu der Bewegungsrichtung der Druckkopfanordnung (20) während eines Druckhubs ausgestaltet ist.

9. Schablonendrucker (10) nach Anspruch 8, wobei die Druckkopfanordnung (20) ferner einen mit dem Rahmen (12) und der Abgabeeinheit (56) verbundenen Verschiebemechanismus beinhaltet, wobei der Verschiebemechanismus zur Auf- und Abwärtsbewegung der Abgabeeinheit (56) in einer z-Achsenrichtung ausgestaltet ist.

10. Verfahren zum Drucken eines Montagematerials auf ein elektronisches Substrat, das Verfahren aufweisend:
Zuführen eines elektronischen Substrats zu einem Schablonendrucker (10);
Positionieren des elektronischen Substrats in einer Druckposition;
Ineingriffbringen einer Schablone (18), die Öffnungen zu dem elektronischen Substrat aufweist;
Ausführen eines Druckhubs mit einem Wischerblatt (78), um Lötpaste durch die Öffnungen der Schablone (18) auf das elektronische Substrat zu drücken; und
Aufbringen von Lötpaste zwischen den Wischerblättern (78) während des Druckhubs;
**gekennzeichnet durch**
das Messen einer Temperatur des innerhalb einer Patrone (68) enthaltenen Montagematerials unter Verwendung eines Sensors (80), wobei der Sensor (80) ein berührungsloser Sensor (80) ist.

11. Verfahren nach Anspruch 10, wobei der berührungslose Sensor (80) ein Infrarotsensor ist.

12. Verfahren nach Anspruch 10, ferner aufweisend die Positionierung des berührungslosen Sensors (80) relativ zu der Patrone (68) durch eine Halterung (82).

13. Schablonendrucker (10) zum Drucken eines Montagematerials auf ein elektronisches Substrat, der Schablonendrucker (10) aufweisend:
einen Rahmen (12);
eine mit dem Rahmen (12) verbundene Schablone (18), wobei die Schablone (18) darin ausgebildete Öffnungen aufweist;
eine mit dem Rahmen (12) verbundene Trägeranordnung (28),
wobei die Trägeranordnung (28) zum Tragen des elektronischen Substrats in einer Druckposition unterhalb der Schablone (18) ausgestaltet ist; und
eine Druckkopfanordnung (20), die derart mit dem Rahmen (12) verbunden ist, dass die Druckkopfanordnung (20) zur Überquerung der Schablone (18) während der Druckhübe ausgestaltet ist, die Druckkopfanordnung (20) beinhaltend:
einen Druckkopfrahmen (36),
eine mit dem Druckkopfrahmen (36) verbundene Wischerblattanordnung (74), wobei die
Wischerblattanordnung (74) die Schablone (18) berührende Wischerblätter (78) aufweist, um während eines Druckvorgangs Lötpaste auf die Schablone (18) zu drucken, wobei die Wischerblätter (78) ausgestaltet sind, Lötpaste durch die Öffnungen der Schablone (18) zu drücken, und
eine mit dem Druckkopfrahmen (36) verbundene Abgabeeinheit (56), wobei die Abgabeeinheit (56) zum Aufbringen von Lötpaste zwischen den Wischerblättern (78) ausgestaltet ist, wobei die Abgabeeinheit (56) eine Patronenaufnahme (66) beinhaltet,
**dadurch gekennzeichnet, dass** die Druckkopfanordnung ferner beinhaltet:
einen mit dem Druckkopfrahmen (36) verbundenen Sensor (80), wobei der Sensor (80) zur Messung einer Temperatur der von der Abgabeeinheit (56) aufgebrachten Lötpaste ausgestaltet ist, wobei der Sensor (80) ein berührungsloser Sensor (80) ist.

14. Schablonendrucker (10) nach Anspruch 13, wobei der berührungslose Sensor (80) ein Infrarotsensor ist.

15. Schablonendrucker (10) nach Anspruch 13, wobei der berührungslose Sensor (80) durch eine Halterung (82) an dem Druckkopfrahmen (36) befestigt ist, wobei die Halterung (82) zur Ausrichtung des berührungslosen Sensors (80) in einem Winkel relativ zu der Aufbringung der Lötpaste ausgestaltet ist.

## Revendications

1. Ensemble de tête d'impression (20) d'une imprimante à stencil (10), l'ensemble de tête d'impression (20) comprenant :
une structure de tête d'impression (36) ;
un ensemble de lame de raclage (74) couplé à la structure de tête d'impression (36), l'ensemble de lame de raclage (74) ayant des lames de raclage (78) qui sont en contact avec le stencil (18) pour imprimer de la pâte à braser sur le stencil (18) durant une course d'impression, les lames de raclage (78) étant configurées pour forcer de la pâte à braser à travers les ouvertures du stencil (18) ;
une unité de distribution (56) couplée à la structure de tête d'impression (36), l'unité de distribution (56) étant configurée pour déposer de la pâte à braser entre les lames de raclage (78), l'unité de distribution (56) comprenant un récepteur de cartouche (66) ; et
une cartouche (68) positionnée dans le récepteur de cartouche (66) ;
**caractérisé en ce que** l'ensemble de tête d'impression comprend en outre :
un capteur (80) couplé à la structure de tête d'impression (36) à proximité de la cartouche (68), le capteur (80) étant configuré pour mesurer une température de la cartouche (68),
dans lequel le capteur (80) est un capteur sans contact (80) .

2. Ensemble de tête d'impression (20) selon la revendication 1, dans lequel le capteur sans contact (80) est un capteur infrarouge.

3. Ensemble de tête d'impression (20) selon la revendication 1, dans lequel le capteur sans contact (80) est fixé à la structure de tête d'impression (36) par une console (82).

4. Imprimante à stencil (10) pour l'impression d'un matériau d'assemblage sur un substrat électronique, l'imprimante à stencil (10) comprenant :
une structure (12) ;
un stencil (18) couplé à la structure (12), le stencil (18) ayant des ouvertures formées dans celui-ci ;
un ensemble de support (28) couplé à la structure (12),
l'ensemble de support (28) étant configuré pour supporter le substrat électronique dans une position d'impression sous le stencil (18) ; et
un ensemble de tête d'impression (20) selon la revendication 1, couplé à la structure (12) de telle manière que l'ensemble de tête d'impression (20) est configuré pour traverser le stencil (18) durant les courses d'impression.

5. Imprimante à stencil (10) selon la revendication 4, dans laquelle le capteur sans contact (80) est un capteur infrarouge.

6. Imprimante à stencil (10) selon la revendication 4, dans laquelle le capteur sans contact (80) est fixé à la structure de tête d'impression (36) par une console (82).

7. Imprimante à stencil (10) selon la revendication 6, dans laquelle la console (82) est configurée pour orienter le capteur sans contact (80) selon un angle par rapport à une orientation de la cartouche (68).

8. Imprimante à stencil (10) selon la revendication 4, dans laquelle l'ensemble de tête d'impression (20) comprend en outre un ensemble de mouvement de translation couplé à la structure (12) et à l'unité de distribution (56), l'ensemble de mouvement de translation étant configuré pour déplacer l'unité de distribution (56) dans une direction transversale à la direction du mouvement de l'ensemble de tête d'impression (20) durant une course d'impression.

9. Imprimante à stencil (10) selon la revendication 8, dans laquelle l'ensemble de tête d'impression (20) comprend en outre un mécanisme coulissant couplé à la structure (12) et à l'unité de distribution (56), le mécanisme coulissant étant configuré pour déplacer l'unité de distribution (56) vers le haut et vers le bas dans une direction d'axe z.

10. Procédé d'impression d'un matériau d'assemblage sur un substrat électronique, le procédé comprenant :
la fourniture d'un substrat électronique à une imprimante à stencil (10) ;
le positionnement du substrat électronique dans une position d'impression ;
l'engagement d'un stencil (18) ayant des ouvertures vers le substrat électronique ;
l'exécution d'une course d'impression avec une lame de raclage (78) pour forcer la pâte à braser à travers les ouvertures du stencil (18) sur le substrat électronique ; et
le dépôt de la pâte à braser entre des lames de raclage (78) durant la course d'impression ;
**caractérisé par**
la mesure d'une température du matériau d'assemblage contenu à l'intérieur d'une cartouche (68) à l'aide d'un capteur (80), dans lequel le capteur (80) est un capteur sans contact (80).

11. Procédé selon la revendication 10, dans lequel le capteur sans contact (80) est un capteur infrarouge.

12. Procédé selon la revendication 10, comprenant en outre le positionnement du capteur sans contact (80) par rapport à la cartouche (68) par une console (82).

13. Imprimante à stencil (10) pour l'impression d'un matériau d'assemblage sur un substrat électronique, l'imprimante à stencil (10) comprenant :
une structure (12) ;
un stencil (18) couplé à la structure (12), le stencil (18) ayant des ouvertures formées dans celui-ci ;
un ensemble de support (28) couplé à la structure (12),
l'ensemble de support (28) étant configuré pour supporter le substrat électronique dans une position d'impression sous le stencil (18) ; et
un ensemble de tête d'impression (20) couplé à la structure (12) de telle manière que l'ensemble de tête d'impression (20) est configuré pour traverser le stencil (18) durant les courses d'impression, l'ensemble de tête d'impression (20) comprenant
une structure de tête d'impression (36),
un ensemble de lame de raclage (74) couplé à la structure de tête d'impression (36), l'ensemble de lame de raclage (74) ayant des lames de raclage (78) qui sont en contact avec le stencil (18) pour imprimer de la pâte à braser sur le stencil (18) durant une course d'impression, les lames de raclage (78) étant configurées pour forcer de la pâte à braser à travers les ouvertures du stencil (18), et
une unité de distribution (56) couplée à la structure de tête d'impression (36), l'unité de distribution (56) étant configurée pour déposer de la pâte à braser entre les lames de raclage (78), l'unité de distribution (56) comprenant un récepteur de cartouche (66),
**caractérisé en ce que** l'ensemble de tête d'impression comprend en outre :
un capteur (80) couplé à la structure de tête d'impression (36), le capteur (80) étant configuré pour mesurer une température de la pâte à braser déposée par l'unité de distribution (56), dans lequel le capteur (80) est un capteur sans contact (80).

14. Imprimante à stencil (10) selon la revendication 13, dans laquelle le capteur sans contact (80) est un capteur infrarouge.

15. Imprimante à stencil (10) selon la revendication 13, dans laquelle le capteur sans contact (80) est fixé à la structure de tête d'impression (36) par une console (82), la console (82) étant configurée pour orienter le capteur sans contact (80) selon un angle par rapport au dépôt de la pâte à souder.
